Europäisches Patentamt

European Patent Office

Office européen des brevets

(11) Publication number: **0 385 007**
**A2**

## EUROPEAN PATENT APPLICATION

(21) Application number: **89302084.2**

(22) Date of filing: **02.03.89**

(51) Int. Cl.5: **H01L 31/0392, H01L 31/20**

(30) Priority: **02.03.88 US 163520**

(43) Date of publication of application:
**05.09.90 Bulletin 90/36**

(84) Designated Contracting States:
**DE FR GB IT NL**

(71) Applicant: **MINNESOTA MINING AND MANUFACTURING COMPANY**
**3M Center, P.O. Box 33427**
**St. Paul Minnesota 55133-3427(US)**

(72) Inventor: **Jeffrey, Frank R. Minnesota Mining and**
**Manufacturing Comp. 2501 Hudson Road**
**P.O.Box 33427**
**St.Paul Minnesota 55133-3427(US)**
Inventor: **Gilbert, James Minnesota Mining and**
**Manufacturing Comp. 2501 Hudson Road**
**P.O.Box 33427**
**St.Paul Minnesota 55133-3427(US)**

(74) Representative: **Baillie, Iain Cameron et al**
**c/o Ladas & Parry Isartorplatz 5**
**D-8000 München 2(DE)**

(54) Sealing of polymeric web surfaces.

(57) A substrate for use in a photovoltaic cell has a polymeric web that has been sealed with a barrier layer on first and second major surfaces such that sorption of atmospheric contaminants by the web is prevented and the web is substantially gas free.

EP 0 385 007 A2

# SEALED POLYMERIC WEB SURFACES

The Government of the United States of America has rights in this invention pursuant to Subcontract ZB-4-03056-2 awarded by the United States Department of Energy.

In the production of amorphous silicon devices on polyimide web substrates, a typical approach involves degassing the polyimide substrate at a temperature approaching the thermal limits of the polyimide (i.e. approximately 350°C) and at pressures in the range of 200-300 millitorr. Next, a conductive metal is sputter deposited on one side of the polyimide web. This metal layer provides an electrical contact on the bottom side of the amorphous silicon layer. At this stage in production, the web with the metal electrical contact deposited on one side is transferred to an amorphous silicon deposition apparatus. The transferring step exposes the polyimide web to the atmosphere. This exposure allows resorption of gasses, especially water vapor, from the atmosphere. Thus, prior to any amorphous silicon deposition, a second degassing step must be performed.

An example of an amorphous silicon device is described in Okaniwa et al. U.S. Patent 4,697,041. The device is a laminated structure formed in a roll-to-roll process as disclosed in U.S. Patent 4,438,723. From bottom to top, the laminated product has a polyimide web, a conductive layer preferably a bimetal layer of aluminum coated with stainless steel, and an amorphous silicon layer. Together, the aluminum and stainless steel layers form a bottom electrode structure in which the aluminum provides high electrical conductivity and the stainless steel overlaying the aluminum provides strength and refractory properties. The resulting product is useful as a solar cell.

The Okaniwa et al. patent also discloses that the electrode layer may be a single layer of stainless steel, although this is less preferred than the laminated layer. The metal electrode layer preferably has a thickness of 0.3 micrometers or more in order to reduce its electrical resistance and to insure sufficient mechanical strength.

U.S. Patent 4,321,299 to Frazer describes a method of making a solar sail using a polyimide film. A support film is used for supporting the polyimide film during processing. Initially, the polyimide film is etched on one side and then coated with an emissivity layer such as chromium. Next, the support film and polyimide film are parted and the polyimide film is coated on an opposite side with a reflective material such as aluminum. The two films are then wound together on a single takeup roll.

U.S. Patent 4,022,585 to Kaye describes a process for sealing and protecting the surface of advanced composite materials against moisture and other contaminants. The surface is first uniformly abraded, and a metal coating is then applied by electroplating. The metal coating is then fluxed and a layer of molten metal is applied to the plate of metal with the metal top coating then being solidified.

U.S. Patent 4,650,984 to Furushima et al., U.S. Patent 4,683,176 to Nakamura et al., U.S. Patent 4,544,571 to Miller, and U.S. Patent 3,981,691 to Cuneo all teach methods of attaching metals to polyimide substrates.

The present invention includes a substrate for use in a photovoltaic cell having a polymeric web that has been sealed with a barrier layer on first and second major surfaces such that sorption of atmospheric contaminants by the web is prevented. The web is sealed by applying a barrier layer, such as stainless steel, to both major surfaces of the web sufficient to prevent sorption of atmospheric contaminants by the web. Preferably, the barrier layer is applied to both major surfaces of the web simultaneously using a single source. Preferably, the web is initially degassed and exposed to an ionized oxygen plasma.

The web is then coated with a conductive layer such as alumimun and on to which an amorphous silicon layer is deposited along with electrodes for cooperating with the silicon to generate a voltage upon the alumimun conductive layer. A light transmissive, electrically conductive layer is deposited over the amorphous silicon layer to form a solar electric cell.

An apparatus for producing the sealed web includes first and second rollers between which the web is transferred. A mechanism for depositing a barrier layer from a single source such as stainless steel is positioned to deposit stainless steel on a portion of the web on the first roller and a portion of the web disposed tangentially to the first roller. Preferably, the apparatus includes a mechanism to degas the web and a mechanism for providing an ionized oxygen plasma to contact the web.

Figure 1 is a block diagram illustrating the steps of the sealing method of the present invention.

Figure 2 is a schematic view of the apparatus used in performing the steps of the sealing method.

Figure 3 is a schematic view of a glow bar used in the method of the present invention.

Figure 4 is a sectional view taken along the line 4--4 in Figure 3.

Figures 5 and 6 are graphs comparing the voltage/current characteristics of amorphous silicon devices prepared with and without the present invention.

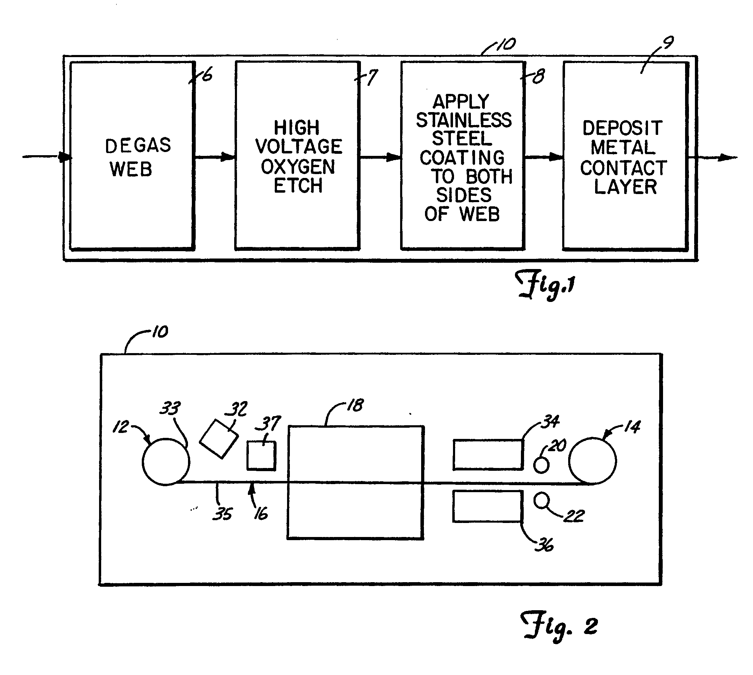

The process for producing the substrate of the present invention is illustrated diagrammatically in Figure 1. The process seals first and second major surfaces of the polymeric web so that the web can be exposed to the atmosphere without absorbing components from the atmosphere during transfer to a second apparatus for deposition of amorphous silicon thereon.

To seal the first and second major surfaces, a roll or web of polymeric film is placed in a vacuum chamber 10, and the web is first degassed at 6. Next, the degassed web is etched or scrubbed on both sides with a high voltage, oxygen etch process 7. The etched web is then coated on both sides with stainless steel 8. The edges of the web are also coated with stainless steel during this step. The stainless steel serves to enclose or seal the web surfaces and, therefore, is a barrier to the transfer of gases to or from the web. At this point in the process, the product is a polyimide web with a sealing layer of stainless steel.

To form an amorphous silicon device from the coated web, a metal, electrically conductive contact layer is deposited at 9. Preferably, the conductive contact layer is an aluminum layer deposited on one side of the stainless steel coated web. After the aluminum is deposited, the web is wound on a roller and then may be transferred to a separate apparatus for deposition of amorphous silicon.

In Figure 2, a schematic view of an apparatus in which the web sealing method may be performed is presented. The apparatus includes a vacuum chamber 10. A first roller 12 and a second roller 14 are disposed within the chamber. A web 16 of polyimide is wound around the first roller 12 and the second roller 14 with a portion of the web 16 extending between the two rollers 12 and 14. The first roller 12 and the second roller 14 rotate in a coordinated fashion such that the web 16 can be transferred back and forth between the two rollers 12 and 14.

A degassing oven 18 is positioned between the first roller 12 and the second roller 14 within the chamber 10. The degassing step 6 (illustrated in Figure 1) of the present process takes place as the web 16 travels through the degassing oven 18 from the first roller 12 toward the second roller 14. In the degassing step, the first roller 12 serves as a feed roller, unwinding the web 16, and the second roller 14 serves as a take-up roller.

The web 16 travels through the degassing oven 18 where it is exposed to controlled temperatures and pressures for a period of time sufficient to degas the web 16. In the situation where the web 16 is made of polyimide, temperatures within the range of 100°C to approximately 400°C may be used to degas the polyimide web 16. The upper temperature is limited by the softening point of the web material 16. Lower temperatures in the degassing oven 18 require progressively longer exposure times to effectively degas the web 16. Temperatures in the range of 300° to 350°C are particularly preferred for the degassing step since they allow reasonable processing times without risking excessive softening of polyimide films.

The degassing of the polyimide web 16 is also encouraged by lower pressures, preferably in the range of 200 to 300 millitorr. At the conclusion of the degassing step, the bulk of the web 16 will be wound around the second roller 14 with an end portion extending back to the first roller 12.

The next step of the method of the present invention is the high voltage oxygen etching or scrubbing 7 (as illustrated in Figure 1) of the surface of the web 16. A pair of oxygen glow bars 20 and 22 are located within the chamber 10, one on each side of the path of the web 16.

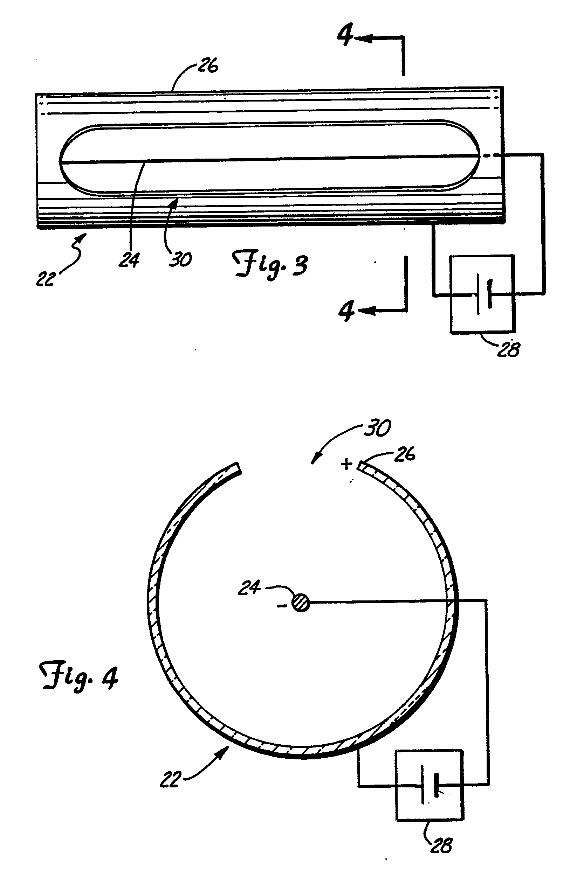

A top view of a schematic of the oxygen glow bar 22 is illustrated in Figure 3 and a cross sectional view of the bar of Figure 3 is illustrated in Figure 4. The oxygen glow bar 22 includes a central electrode 24 and an exterior electrode 26. The electrodes 24 and 26 are conductively connected to a high voltage power source 28 such that the central electrode 24 has a negative charge and the exterior electrode 26 has a positive charge. Additionally, the outer electrode 26 includes a slot spanning the width of the web 16. Oxygen that flows within the glow bar 22 becomes ionized and exits through the slot 30. The charged and accelerated oxygen ions form a plasma and etch or scrub the surface of the web 16. Glow bar 20 is similar in design, but opens downwardly rather than upwardly, so as to etch or scrub the top side of the web 16.

For the high voltage, oxygen etching or scrubbing step, pressures of 70 millitorr are appropriate. The applied voltage may be from 1 to 10 kilovolts as taught in U.S. Patent 4,321,299. Preferably, voltages of approximately 5.5 kilovolts are employed.

The stainless steel coating step 8 (as illustrated in Figure 1) occurs next. During the stainless steel coating step, DC magnetron sputtering is employed to coat both sides of the previously etched web 16. Although the sputtering is not specifically directed toward the edges of the web, the edges are also coated. Effectively, this coating encloses the web, by covering both sides and edges of the web.

Two separate sputter units, one on each side of the web, may be employed. However, in a particularly preferred embodiment of this invention, a single stainless steel sputtering unit 32 is employed to coat both sides of the previously etched web 16. The target of the sputtering unit 32 is oriented such that it applies stainless steel to the outside exposed surface 33 of web 16 wound on the first roller 12 and simultaneously applies stainless steel to the opposite side 35 of the web 16 as the web is extended tangentially from the first roller towards the second roller 14.

The stainless steel is sputtered using argon gas. In a preferred embodiment, a temperature of about 200° C, an argon pressure of about 2 millitorr and a voltage of approximately 410 volts are used. At the end of this step, the web 16 is wound about the second roller 14 with a small leader section leading to the first roller 12. The resulting stainless steel coating can be from 10 angstroms up to 10 mils in thickness. A preferred range for the stainless steel coat is from 100 angstroms to 1 mil. At a coating thickness of 1 mil, excellent flexibility still remains with the web 16. In a most preferred embodiment, a stainless steel coating of approximately 100 angstroms is applied. Although any suitable stainless steel composition may be sputtered, a 304 type stainless is preferred.

Although stainless steel has been specifically discussed as a barrier layer, other inorganic layers that are suitable include chromium, titanium, and molybdenum. Chromium (III) oxide ($Cr_2O_3$), titanium dioxide ($TiO_2$) and titanium nitride (TiN) may also be used as barrier layers. $SiO_x$ is also a suitable material for a barrier layer.

To form an amorphous silicon device, such as a solar cell, from the stainless steel sealed polyimide web, an aluminum coat is applied (as illustrated in step 9 of Figure 1) to one side of the stainless steel coated web 16. To coat the web with aluminum, the web 16 is wound from the second roller 14 to the first roller 12 and past a DC magnetron sputtering unit 34 for depositing aluminum. Argon gas is used to sputter, preferably at a pressure of about 30 millitorr. To assist in controlling the process temperature in this step, a heater 36 is preferably positioned on the opposite side of the web 16 from the aluminum sputtering unit 34. Using the heater, a preferred temperature of about 200° C is maintained. A suitable voltage for the aluminum sputtering is approximately 375 volts. The resulting aluminum layer serves as an effective electrode in an amorphous silicon device. The web is then wrapped about the first roller 12, with a short leader section extending to the second roller 14.

Optionally, a thin coating of titanium nitride may be applied over the aluminum layer to prevent oxidation of the aluminum layer once the web is removed from the vacuum chamber. The titanium nitride is applied by sputtering using a DC magnetron 37 as illustrated in Figure 2. The web is once again transferred from the first roller 12 to the second roller 14 during sputtering.

After the web has been sealed, the web 16 is removed and transferred to a second apparatus (not shown) for depositing an amorphous silicon layer. During the transfer, the web is exposed to the atmosphere. However, the impermeable layer of stainless steel prevents sorption of moisture and extraneous gases from the atmosphere by the web. The stainless steel layer eliminates the need to degas the web 16 a second time prior to amorphous silicon deposition. Prior art webs needed to be degassed since the moisture sorbed by such webs would provide a contaminant in the silicon layer.

The stainless steel coated web with one side coated with aluminum and, optionally, titanium, serves as a substrate for the deposition of amorphous silicon. The amorphous silicon is deposited at a temperature of 250° C in a conventional manner. The amorphous silicon is doped by using well known methods to provide a p-n junction or a p-i-n layer arrangement which is deposited on the aluminum, or optionally on the titanium layer. Additionally, a light transmissive electrode layer may be deposited upon the amorphous silicon layer. Any typical light transmissive electrode layer suitable for use in amorphous silicon devices may be used, for example, indium oxide, tin oxide, cadmium stannate or indium tin oxide. The resulting laminate is useful as a solar cell.

The following example is intended to be purely exemplary and is not intended to limit the present invention in any way.

Example

A polyimide web 4 inches wide and 2 mils thick was placed in a vacuum chamber 10 schematically illustrated in Figure 2. At a chamber pressure of approximately 200 to 300 millitorr, the web 16 was passed through the degassing oven section 18 at a temperature of approximately 320° C by transfer from roller 12 to roller 14. The web 16 traveled through the oven 18 at a speed of approximately 5 inches per minute.

Next, the travel direction of the degassed web was reversed passing the web between the pair of oxygen glow bars. The oven section temperature was approximately 200° C. The pressure in the chamber 10 was approximately 70 millitorr. The web 16 traveled at about 8 inches per minute. A voltage of 5,000 volts was applied to the glow bars 20 and 22 and oxygen flowed into the glow bars 20 and 22 at a rate of 19 standard cubic centimeters per minute (SCCM) in order to etch or scrub the surface of the degassed web 16.

Following the etching step, the travel direction of the web was again reversed and stainless steel was sputtered from the single DC magnetron sputtering device 32 near the feed roller 12. This single sputtering device applied stainless steel to both sides of the exposed surfaces of the etched web. During this step, the temperature within the oven section was approximately 200°C. The web was transferred from the roller 14 to roller 12 at a speed of about 7 inches per minute. The chamber partial pressure of argon was 2 millitorr. Argon gas was supplied to the DC magnetron sputtering unit at a rate of 25 SCCM. The sputtering unit was operated at a voltage of approximately 410 volts and 500 watts. The sputtering target was approximately 4 inches by 6 inches with an oval sputtering track.

Next, an aluminum layer was applied to one side of the stainless steel coated web using the second DC magnetron sputtering unit 34. During the aluminum sputtering step, the oven section temperature was approximately 200°C, the web traveled at a speed of about 2 inches per minute and the chamber pressure was about 30 millitorr. Argon gas was supplied to the DC magnetron sputtering unit at a rate of 30 SCCM. The DC magnetron was operated at approximately 375 volts and 480 watts.

The roll was then removed from the chamber and placed in a second chamber for the deposition of amorphous silicon. During the transfer of the roll, the web was exposed to the atmosphere of the room.

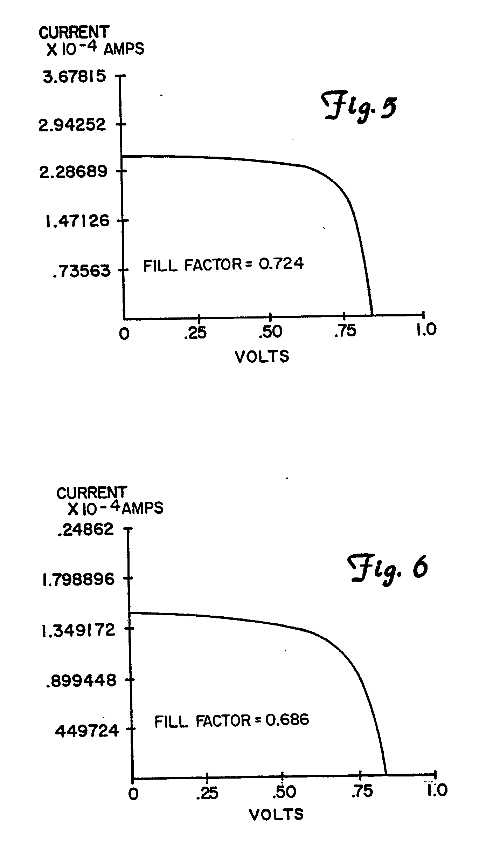

Amorphous silicon was deposited at a temperature of about 250°C in a conventional manner. A top light transmissive electrode was then added upon the amorphous silicon layer. The product of this example was compared to a silicon product made essentially the same way except that the polyimide was not coated on both sides with a stainless steel layer. The comparative results are shown in Figures 5 and 6.

In Figure 5, a graph showing the voltage-current characteristics of a solar cell produced by the process of this example is presented. In Figure 6, the current-voltage characteristics of a similar device without the enclosing layer of stainless steel is presented. Note that the fill factor of the device of this invention is approximately 5% better than the device without the invention. Fill factor is the fraction of the theoretical product of the short circuit current multiplied by the open circuit voltage enclosed by the observed current voltage curve. A theoretical or perfect curve would be rectangular and have a fill factor of 1.00. Repetitions of this example typically provide improvements in the fill factor of 5-10% over devices made without the benefit of this invention.

Additionally, solar devices formed on a polyimide substrate with an impermeable stainless steel coating on both sides are produced with approximately 25% better yields than devices produced by the prior art method. By yield is meant the ratio (percentage) of non-shorted 0.3 cm$^2$ devices to total 0.3 cm$^2$ devices on a 3 inch by 4 inch sample of web.

Although the following theoretical explanation is not considered limiting in this invention, the improvements in fill factor and yield are currently theorized by the applicants to result from the severe restriction or complete elimination of the release of undesirable gases from the web and the resorbtion of water vapor by the web and the subsequent release of moisture during the deposition of amorphous silicon. Thus, this invention is thought to provide control of contaminants, such as unattached byproducts of polymerization and resorbed water vapor, from polyimide webs during the high temperatures and low pressures required for the production of high quality amorphous silicon devices. The contaminants interfere with the deposition of amorphous silicon. Elimination of the contaminants by a sealing coat allows materials such as polyimide to be more effectively employed as substrates. Additionally, the inherent flexibility and relatively low costs associated with polyimide substrates are preserved by the process of the present invention.

Although the present invention has been described with reference to preferred embodiments, workers skilled in the art will recognize that changes may be made in form and detail without departing from the spirit and scope of the invention.

## Claims

1. A substrate for use in a photovoltaic cell comprising:
a polymeric web having first and second major surfaces sealed with a barrier layer such that sorption of atmospheric contaminants by the web is prevented and the web is substantially gas free.

2. The substrate of claim 1 wherein the polymeric web is a polyimide web.

3. The substrate of claim 1 wherein the polymeric web is processed to drive out moisture prior to the web being sealed.

4. An amorphous silicon device including the substrate of claim 1 and an electrically conductive layer deposited on the barrier layer and an amorphous silicon layer deposited on the electrically conductive layer.

5. The device of claim 4 wherein a light transmissive, electrically conductive layer is deposited over the amorphous silicon layer to form a photovoltaic cell.

6. A method for producing the substrate of claim 1 by applying the barrier layer to the first and second major surfaces of the web simultaneously.

7. The method of claim 6 wherein the web is wound on or off a roller and a sputtering source is positioned to simultaneously sputter toward the first major surface of the web positioned on the roller and toward the second major surface of the web disposed tangentially to the roller thereby coating both surfaces of the web simultaneously.

8. The method of claim 6 and further including: coating one of the surfaces of the sealed web with aluminum to form an electrically conductive layer of aluminum; and
depositing an amorphous silicon layer and electrode means for cooperating with the silicon to generate a voltage upon the aluminum conductive layer.

EP 0 385 007 A2

```
┌─────────────────────────────────────────────────────────────────────────┐
│  ┌──────────┐      ┌──────────┐      ┌──────────┐      ┌──────────┐      │
│  │          │⌐6    │  HIGH    │⌐7    │  APPLY   │⌐8    │          │  ⌐9   │
│  │  DEGAS   │      │ VOLTAGE  │      │STAINLESS │      │ DEPOSIT  │       │
│  │   WEB    │──────│ OXYGEN   │──────│  STEEL   │──────│  METAL   │──────→│
│  │          │      │  ETCH    │      │ COATING  │      │ CONTACT  │       │
│  │          │      │          │      │ TO BOTH  │      │  LAYER   │       │
│  │          │      │          │      │  SIDES   │      │          │       │
│  │          │      │          │      │ OF WEB   │      │          │       │
│  └──────────┘      └──────────┘      └──────────┘      └──────────┘      │
└─────────────────────────────────────────────────────────────────────────┘
                                                                    ⌐10
```

*Fig.1*

*Fig. 2*

*Fig. 3*

*Fig. 4*

CURRENT
X 10⁻⁴ AMPS

3.67815

2.94252

2.28689

1.47126

.73563

FILL FACTOR = 0.724

$Fig. 5$

0       .25      .50      .75      1.0

VOLTS

CURRENT
X 10⁻⁴ AMPS

.24862

1.798896

1.349172

.899448

449724

FILL FACTOR = 0.686

$Fig. 6$

0       .25      .50      .75      1.0

VOLTS